Europäisches Patentamt

European Patent Office

Office européen des brevets

(11)　EP 0 716 503 B1

(19)

(12)　**FASCICULE DE BREVET EUROPEEN**

(45) Date de publication et mention
de la délivrance du brevet:
**19.04.2000  Bulletin 2000/16**

(51) Int Cl.⁷: **H03F 1/30**, H03F 3/45

(21) Numéro de dépôt: **95203254.8**

(22) Date de dépôt: **27.11.1995**

(54) **Amplificateur à taux de distorsion réduit**

Verstärker mit reduzierter Verzerrung

Amplifier with reduced distortion

(84) Etats contractants désignés:
**DE FR GB IT**

(30) Priorité: **07.12.1994  FR 9414730**

(43) Date de publication de la demande:
**12.06.1996  Bulletin 1996/24**

(73) Titulaire: **Koninklijke Philips Electronics N.V.
5621 BA Eindhoven (NL)**

(72) Inventeur: **Philippe, Pascal
F-75008 Paris (FR)**

(74) Mandataire: **Charpail, François et al
Société Civile S.P.I.D.
156, Boulevard Haussmann
75008 Paris (FR)**

(56) Documents cités:
**US-A- 4 543 538          US-A- 5 307 024**

• **PATENT ABSTRACTS OF JAPAN vol. 8 no. 36
(E-227) ,16 Février 1984 & JP-A-58 195306
(FUJITSU K.K.) 14 Novembre 1983,**

## Description

La présente invention concerne un amplificateur comportant un premier transistor de sortie et un deuxième transistor de sortie d'une même polarité et en configuration de type "push-pull", ainsi qu'un transistor d'entrée dont le collecteur est couplé à la base du premier transistor de sortie.

Un tel amplificateur est notamment connu du document JP-A-58-195306. Il peut être réalisé sous forme intégré en utilisant seulement des transistors de type NPN de sorte que cet amplificateur est apte à travailler à fréquence relativement élevée.

En tant qu'amplificateur à fréquence intermédiaire pour des signaux de télévision, l'amplificateur connu n'est pas totalement satisfaisant à différents point de vue :

Par sa structure asymétrique, cet amplificateur ne permet pas d'éliminer des signaux parasites qui peuvent se superposer au signal d'entrée et se trouvent amplifiés ainsi avec le signal utile. Une structure différentielle plutôt qu'asymétrique permettrait de remédier à cet inconvénient. Dans ce but on peut penser à compléter l'amplificateur connu par une deuxième partie, symétrique de la première, et à exploiter les deux entrées et les deux sorties de cette structure en mode différentiel. Cette solution cependant ne présente pas un taux suffisant de réjection de mode commun.

Par ailleurs, il serait également souhaitable de disposer d'un amplificateur dont la linéarité serait améliorée.

L'invention a donc pour but de proposer un amplificateur dont les performances sont affectées dans une moindre mesure par les limitations indiquées précédemment.

En effet, selon la présente invention, un amplificateur du type mentionné dans le paragraphe introductif est caractérisé en ce qu'il comporte en outre un troisième et un quatrième transistor de sortie lesquels sont également agencés en configuration "push-pull", ainsi qu'un transistor d'entrée supplémentaire dont l'émetteur est couplé à l'émetteur du dit transistor d'entrée et dont le collecteur est couplé à la base du deuxième transistor de sortie et à la base du troisième transistor de sortie, la base du quatrième transistor de sortie étant couplée au collecteur du dit transistor d'entrée.

Par sa structure rendue aisément symétrique, l'amplificateur selon l'invention peut fonctionner selon un mode réellement différentiel puisque la base du deuxième transistor de sortie n'est plus connectée à l'émetteur du transistor d'entrée.

Ainsi, un mode avantageux de mise en oeuvre de l'invention prévoit que le dit transistor d'entrée et le transistor d'entrée supplémentaire sont agencés entre eux en paire différentielle, et en particulier que l'émetteur du dit transistor d'entrée et l'émetteur du transistor supplémentaire d'entrée sont alimentés chacun par une source de courant et sont couplés entre eux par une résistance dite première résistance d'émetteur.

La structure symétrique de l'amplificateur permet de choisir des conditions de polarisation en courant continu des transistors du circuit de manière indépendante des dispositions spécifiques correspondant à la réduction de distorsion du signal amplifié.

Selon un mode de mise en oeuvre préféré de l'invention, le couplage entre le collecteur du dit transistor d'entrée et la base du quatrième transistor de sortie est assuré par un transistor annexe au premier transistor de sortie, dont la base est connectée à la base du premier transistor de sortie, fournissant par son émetteur un signal de tension dont une fraction est appliquée à la base du quatrième transistor de sortie, et symétriquement, le couplage entre le collecteur du transistor d'entrée supplémentaire et la base du deuxième transistor de sortie est assuré par un transistor annexe au troisième transistor de sortie, dont la base est connectée à la base du troisième transistor de sortie fournissant par son émetteur un signal de tension dont une fraction est appliquée à la base du deuxième transistor de sortie.

Avantageusement, la fraction des tensions appliquées respectivement aux bases des deuxième et quatrième transistors de sortie est prélevée sur un pont diviseur qui inclut une diode en série dans une de ses branches. Cette diode favorise la stabilité de fonctionnement de l'amplificateur en fonction des variations de température.

Un paramètre de réglage supplémentaire pour le fonctionnement des deuxième et quatrième transistors de sortie permettant un contrôle du courant et de la linéarité du signal délivré par ces transistors est obtenu par le fait que l'émetteur du deuxième transistor de sortie et l'émetteur du quatrième transistor de sortie sont couplés entre eux par une résistance dite deuxième résistance d'émetteur.

Comme le signal de tension présent sur l'émetteur du transistor annexe au premier transistor de sortie est un signal déjà amplifié par le transistor d'entrée, un pont diviseur permet de choisir à volonté l'amplitude du signal à appliquer à la base du quatrième transistor de sortie et réciproquement en ce qui concerne le transistor annexe au troisième transistor de sortie et le transistor d'entrée supplémentaire pour obtenir un fonctionnement optimal de l'amplificateur, et en particulier une bonne linéarité du signal de sortie.

La linéarité est encore améliorée par une disposition prévoyant qu'une résistance de contre-réaction est directement connectée entre le point commun des premier et deuxième transistors de sortie et la base du dit transistor d'entrée, et une autre résistance de contre-réaction, directement connectée entre le point commun des troisième et quatrième transistors de sortie et la base du transistor de sortie supplémentaire.

Ce rétro-couplage direct est rendu possible par le fait que le point de repos de l'amplificateur selon l'invention peut être réglé de manière précise et sans devoir satisfaire à un compromis comme c'était le cas avec l'amplificateur de l'art antérieur. Un taux de contre-réaction peut être réglé par la valeur de la résistance de contre-réaction pour obtenir un taux de distorsion déterminé qui est indépendant de la fréquence du signal.

Selon ce mode de réalisation il y a avantage qu'une résistance dite de base soit connectée entre une tension de mode commun et, d'autre part, la base du dit transistor d'entrée respectivement d'autre part, la base du transistor supplémentaire d'entrée.
Un signal de plus grande amplitude peut donc être fourni en sortie de l'amplificateur.

La description qui va suivre en regard des dessins annexés, donnés à titre d'exemples non limitatifs, fera bien comprendre comment l'invention peut être réalisée.

La figure 1 représente un schéma d'un amplificateur de l'art antérieur, et

la figure 2 montre le schéma électrique d'un exemple d'amplificateur selon l'invention.

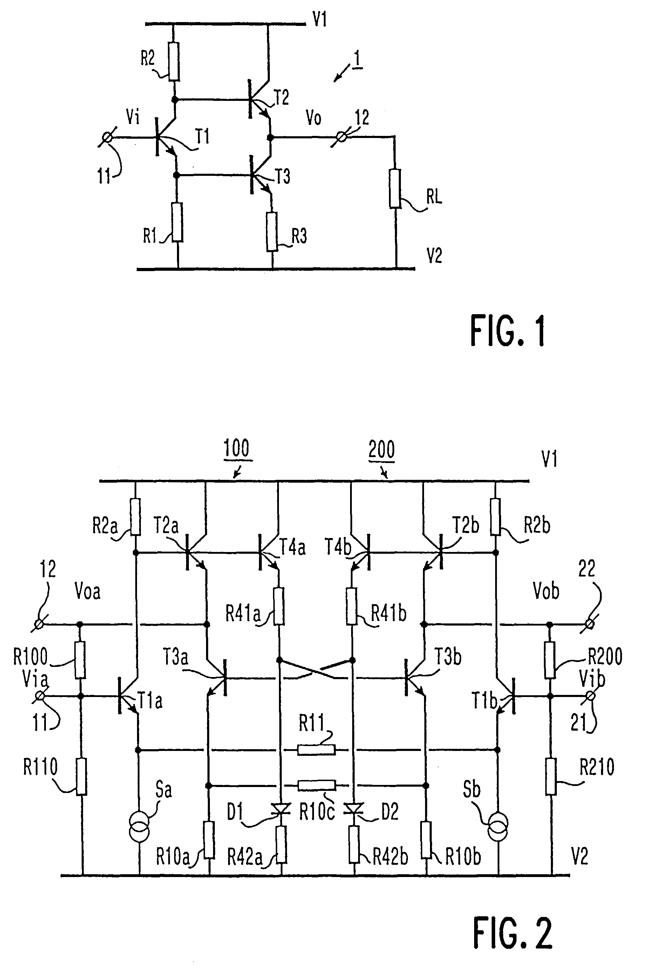

La figure 1 représente le schéma d'un amplificateur connu qui comporte un module 1 alimenté entre une première source d'alimentation V1 et une deuxième source d'alimentation V2 servant de référence de tension, module qui est composé d'une part d'un premier transistor T1 de type NPN agencé pour fonctionner en émetteur commun et qui reçoit sur sa base un signal alternatif d'entrée Vi à partir d'une borne d'entrée 11. L'émetteur du transistor T1 est relié à la source d'alimentation de référence V2 à travers une résistance d'émetteur R1. Le collecteur du transistor T1 est relié à la source d'alimentation V1, positive, à travers une résistance de collecteur R2. Le module 1 comporte d'autre part un deuxième transistor NPN T2 qui fonctionne en émetteur-suiveur de la tension développée sur le collecteur du transistor T1, tension qui est appliquée sur sa base. Il délivre un signal de sortie Vo à une borne de sortie 12 connectée à son émetteur, borne qui est destinée à être connectée à une résistance de charge RL connectée par ailleurs à la tension de référence V2. Le module 1 comporte encore un troisième transistor T3 également de type NPN qui a sa base connectée à l'émetteur du premier transistor T1 et qui est agencé pour fonctionner en émetteur commun, son collecteur étant connecté à l'émetteur du deuxième transistor T2 et son émetteur relié à la tension de référence V2 à travers une résistance d'émetteur R3. De ce fait le transistor T3 reçoit sur sa base un signal en phase avec le signal d'entrée Vi et son collecteur débite sur la résistance de charge RL un courant alternatif qui est en opposition de phase avec la tension fournie par l'émetteur du deuxième transistor T2.

Ainsi les deuxième et troisième transistors T2, T3 fonctionnent en mode push-pull. En prenant comme critères d'optimisation la puissance du signal délivré sur la charge et la distorsion de ce signal, il apparaît que les meilleures conditions de fonctionnement sont celles où l'amplitude du courant alternatif délivré par T3 serait sensiblement égale à celle du courant délivré par T2.

Un calcul très simplifié des conditions correspondantes aboutit alors à la relation entre les valeurs de résistances :

$$\frac{R2}{R1} = 2 \cdot \frac{RL}{R3}$$

relation dans laquelle les valeurs des résistances sont représentées par le signe de référence de ces résistances.

Or le rapport $\frac{R2}{R1}$ fixe la valeur du gain en tension de cet amplificateur alors que la valeur de R1 doit être suffisamment élevée pour qu'une tension continue appliquée à la base du transistor T3 soit susceptible de faire conduire ce transistor. Lorsque la tension d'alimentation (V1 - V2) n'est pas plus élevée que 5 volts, il est donc nécessaire d'utiliser un rapport $\frac{R2}{R1}$ faible (proche de l'unité) auquel cas la linéarité de l'amplificateur sera satisfaisante mais son gain en tension insuffisant.

Il serait souhaitable au contraire de disposer d'un amplificateur qui ne soit pas sujet à de telles limitations, qui présente un gain en tension plus élevé, de l'ordre de 10 par exemple, et pour lequel une contre-réaction puisse être appliquée indépendamment de la fréquence du signal, par liaison directe entre la sortie et l'entrée au moyen d'une résistance de contre-réaction. De plus, en utilisant un mode de fonctionnement symétrique, il serait avantageux d'améliorer le taux de réjection de mode commun obtenu par l'amplificateur connu qui est insuffisant.

La figure 2 présente le schéma électrique d'un amplificateur selon l'invention. L'amplificateur de la figure 2 est d'un type symétrique par l'adjonction à un premier module 100 d'un deuxième module 200 qui est semblable au premier module. Le premier module 100 comporte une borne d'entrée 11 pour un signal d'entrée Via et une borne de sortie 12 pour un signal de sortie Voa tandis que le deuxième module 200 dispose d'une borne d'entrée 21 pour un signal d'entrée Vib et une borne de sortie 22 pour un signal de sortie Vob. Les signaux d'entrée Via et Vib ne sont pas nécessairement des signaux complémentaires du point de vue alternatif, tandis que les signaux de sortie Voa et Vob sont rendus complémentaires. Ils correspondent à la différence (Via - Vib) des signaux d'entrée multipliée par le gain de l'amplificateur.

La borne d'entrée 11 du module 100 est reliée à la base d'un premier transistor T1a agencé pour fonctionner en émetteur commun et dont le collecteur est relié à la source d'alimentation positive V1 à travers une résistance de collecteur R2a. De manière symétrique, l'entrée de signal 21 du module 200 est reliée à la base d'un deuxième transistor d'entrée T1b, symétrique du transistor T1a dont le collecteur est couplé à la source d'alimentation V1 via une résistance de collecteur R2b. Les transistors T1a et T1b sont agencés en paire différentielle du fait de leurs émetteurs réunis à travers une résistance d'émetteur R11. Chacun de ces émetteurs est couplé par ailleurs à la source d'alimentation de référence V2 via respectivement une source de courant Sa dans le premier module 100 et une source de courant Sb dans le deuxième module 200. Le module 100 comporte également un premier transistor de sortie T2a dont la base est connectée au collecteur du transistor T1a et qui est agencé en émetteur-suiveur, son émetteur étant connecté à la borne de sortie 12. Un deuxième transistor de sortie T3a a son collecteur connecté à l'émetteur du transistor T2a et son émetteur couplé à la deuxième source d'alimentation V2 via une résistance d'émetteur R10a.

Une disposition symétrique est réalisée dans le deuxième module 200 avec les transistors T2b dont la base est connectée au collecteur du transistor T1b, dont l'émetteur est connecté à la borne de sortie 22 ainsi qu'au collecteur d'un transistor T3b lequel à son émetteur relié à la source d'alimentation V2 via une résistance d'émetteur R10b. Pour que les paires de transistors T2a, T3a et T2b, T3b fonctionnent en mode push-pull comme c'était le cas de l'amplificateur connu de la figure 1, il est nécessaire que les transistors T3a respectivement T3b, reçoivent sur leur base un signal en phase avec le signal d'entrée correspondant du même module.

Dans ce but, le module 100 comporte encore un transistor annexe T4a ayant sa base couplée à la base du transistor T2a ainsi qu'au collecteur du transistor T1a et, de manière symétrique, le module 200 comporte également un transistor annexe T4b dont la base est couplée à la base du transistor T2b ainsi qu'au collecteur du transistor T1b. Les transistors T4a et T4b fonctionnent en émetteur-suiveur, ayant leur collecteur alimenté par la source d'alimentation V1 tandis que l'émetteur de chacun de ces transistor est connecté à un pont diviseur formé respectivement et dans l'ordre d'une résistance R41a, une diode D1 et une résistance R42a en ce qui concerne le pont diviseur du module 100, et en ce qui concerne le module 200, un pont diviseur comportant successivement une résistance 41b, une diode D2 et une résistance R42b. Si sur la figure, des diodes ont été représentées en D1 et D2, il est clair toutefois que celles-ci peuvent être avantageusement réalisées sous la forme de transistors NPN, connectés en diode dans le sens direct. Le point intermédiaire du pont diviseur du module 200, entre la résistance R41b et la diode D2, est connecté à la base du transistor T3a du module 100. Réciproquement, le point intermédiaire du pont diviseur du module 100, entre la résistance R41a et la diode D1, est connecté à la base du transistor T3b du module 200. Dans chacun des modules, en effet, le pont diviseur est soumis à une tension en opposition de phase avec la tension d'entrée du même module. Par contre, la base du deuxième transistor de sortie de l'un des module étant connectée au point intermédiaire du pont diviseur de l'autre module, la condition que le signal appliqué sur cette base soit en phase avec le signal d'entrée dans le même module se trouve réalisée.

Le point intermédiaire des deux ponts diviseurs détermine, en fonction du rapport de division, la tension de polarisation continue appliquée à la base des transistors T3a et T3b ainsi que l'amplitude de la tension de signal alternatif qui y est fournie. Les résistances d'émetteur R10a et R10b des transistors T3a et T3b permettent toutefois d'ajuster l'amplitude du courant alternatif débité par ces transistors en fonction des valeurs choisies pour ces résistances.

Dans cet amplificateur, il est aisé d'obtenir que l'amplitude du courant alternatif débité par les transistors T3a et T3b soit pratiquement égale à celle du courant débité par les transistors T2a et T2b, et sans avoir de contrainte particulière en ce qui concerne le gain de l'amplificateur.

Un degré de liberté supplémentaire concernant l'indépendance de réglage des conditions de polarisation en courant continu vis-à-vis des conditions de fonctionnement en alternatif (gain et linéarité) est fourni par la présence d'une résistance d'émetteur R10c reliant les émetteurs des transistors T3a et T3b. Cette résistance n'a pas d'effet sur la polarisation des transistors T3a et T3b en courant continu alors que sa valeur agit, en parallèle avec les résistances R10a et R10b, sur l'amplification en courant de ces mêmes transistors.

Il en va de manière similaire à propos des transistors T1a et T1b et de leur résistance d'émetteur R11 qui permet d'ajuster précisément le gain et la distorsion de l'amplificateur compte-tenu des performances du second étage formé par les transistors T2a, T2b, T3a, T3b, T4a et T4b.

L'amplificateur décrit à la figure 2 est apte à délivrer des signaux de forte amplitude en sortie contrairement à l'amplificateur connu représenté à la figure 1.

D'autre part, l'amplificateur selon l'invention peut être réglé avec une précision suffisante pour qu'une contre-réaction soit possible par connexion directe d'une résistance entre l'entrée et la sortie sans difficulté de stabilité du circuit en fonction de la température. Ce réglage peut être réalisé par un choix approprié des valeurs des résistances ainsi que des courants d'alimentation fournis par les sources de courant Sa et Sb. Comme représenté à la figure 2, dans le premier module 100, la borne de sortie 12 est reliée à la borne d'entrée 11 via une résistance de contre-réaction R100 et de même dans le deuxième module 200, la borne de sortie 22 est reliée à la borne d'entrée 21 via une résistance de contre-réaction R200.

Lorsqu'une telle contre-réaction, qui reste optionnelle, est appliquée, il est alors avantageux de prévoir une résistance en parallèle entre la base de chacun des transistors T1a et T1b, et la tension de référence V2, comme indiqué par les références R110 et R210 sur la figure . Ces résistances permettent, par la chute de tension produite dans les résistances R100 et R200, d'augmenter la tension base-collecteur des transistors T1a et T1b. Ces transistors T1a et T1b sont donc susceptibles de produire des signaux dont l'excursion de tension sur leur collecteur est relativement élevée permettant d'obtenir un signal différentiel de sortie de 2,5 Volts crête conservant une bonne linéarité, pour une tension d'alimentation de 5 Volts.

Le spécialiste du domaine est à-même d'apporter des modifications de détail par rapport à l'amplificateur décrit à titre d'exemple, notamment en ce qui concerne le point de fonctionnement en courant continu et sa stabilité par rapport aux variations de la température et aux variations de la tension d'alimentation (V2-V1).

De telles modifications restent néanmoins dans le cadre de l'invention telle que revendiquée ci-après.

## Revendications

1. Amplificateur comportant un premier transistor de sortie (T2a) et un deuxième transistor de sortie (T3a), d'une même polarité et en configuration de type "push-pull", ainsi qu'un transistor d'entrée (Tla) dont le collecteur est couplé à la base du premier transistor de sortie (T2a),
caractérisé en ce que l'amplificateur comporte en outre un troisième (T2b) et un quatrième (T3b) transistor de sortie lesquels sont également agencés en configuration "push-pull", ainsi qu'un transistor d'entrée supplémentaire (T1b) dont l'émetteur est couplé à l'émetteur du dit transistor d'entrée (T1a) et dont le collecteur est couplé à la base du deuxième transistor de sortie (T3a) et à la base du troisième transistor de sortie (T2b), la base du quatrième transistor de sortie (T3b) étant couplée au collecteur du dit transistor d'entrée (T1a).

2. Amplificateur selon la revendication 1, caractérisé en ce que le couplage entre le collecteur du dit transistor d'entrée (T1a) et la base du quatrième transistor de sortie (T3b) est assuré par un transistor (T4a) annexe au premier transistor de sortie, dont la base est connectée à la base du premier transistor de sortie (T2a), fournissant par son émetteur un signal de tension dont une fraction est appliquée à la base du quatrième transistor de sortie (T3b), et symétriquement, le couplage entre le collecteur du transistor d'entrée supplémentaire (T1b) et la base du deuxième transistor de sortie (T3a) est assuré par un transistor (T4b) annexe au troisième transistor de sortie, dont la base est connectée à la base du troisième transistor de sortie (T2b) fournissant par son émetteur un signal de tension dont une fraction est appliquée à la base du deuxième transistor de sortie (T3a).

3. Amplificateur selon la revendication 2, caractérisé en ce que le dit transistor d'entrée (T1a) et le transistor d'entrée supplémentaire (T1b) sont agencés en paire différentielle.

4. Amplificateur selon la revendication 2, caractérisé en ce que la fraction des tensions appliquées respectivement aux bases des deuxième (T3a) et quatrième (T3b) transistors de sortie est prélevée sur un pont diviseur qui inclut dans une de ses branches une diode (D1, D2) en série.

5. Amplificateur selon la revendication 3, caractérisé en ce que l'émetteur du dit transistor d'entrée (T1a) et l'émetteur du transistor supplémentaire d'entrée (T1b) sont alimentés chacun par une source de courant et sont couplés entre eux par une résistance dite première résistance d'émetteur (R11).

6. Amplificateur selon la revendication 5, caractérisé en ce que l'émetteur du deuxième transistor de sortie (T3a) et l'émetteur du quatrième transistor de sortie (T3b) sont couplés entre eux par une résistance dite deuxième résistance d'émetteur (R10c).

7. Amplificateur selon l'une des revendications 1 à 6, caractérisé en ce qu'une résistance de contre-réaction (R100) est directement connectée entre le point commun des premier (T2a) et deuxième (T3a) transistors de sortie et la base du dit transistor d'entrée (T1a), et une autre résistance de contre-réaction (R200), directement connectée entre le point commun des troisième (T2b) et quatrième (T3b) transistors de sortie et la base du transistor de sortie supplémentaire (T1b).

8. Amplificateur selon la revendication 7, caractérisé en ce qu'une résistance dite de base (R110, R210) est connecté entre une tension de mode commun (V2) et, d'une part, la base du dit transistor d'entrée (T1a), respectivement d'autre part, la base du transistor supplémentaire d'entrée (T1b).

## Patentansprüche

1. Verstärker mit einem ersten Ausgangstransistor (T2a) und einem zweiten Ausgangstransistor (T3a) selber Polarität und einer Konfiguration vom Typ "push-pull" sowie einen Eingangstransistor (T1a), dessen Kollektor an die Basis des ersten Ausgangstransistors (T2a) gekoppelt ist,
dadurch gekennzeichnet, daß er zudem einen dritten (T2b) und einen vierten (T3b) Ausgangstransistor enthält, die ebenfalls in einer "Push-pull"-Konfiguration angeordnet sind, sowie einen zusätzlichen Eingangstransistor (T1b), dessen Emitter an den Emitter des besagten Eingangstransistors (T1a) gekoppelt ist und dessen Kollektor an die Basis des zweiten Ausgangstransistors (T3a) und an die Basis des dritten Ausgangstransistors (T2b) gekoppelt ist, wobei die Basis des vierten Ausgangstransistors (T3b) an den Kollektor des besagten Eingangstransistors (Tla) gekoppelt ist.

2. Verstärker nach Anspruch 1, dadurch gekennzeichnet, daß die Kopplung zwischen dem Kollektor des besagten Eingangstransistors (T1a) und der Basis des vierten Ausgangstransistors (T3b) von einem Nebentransistor (T4a) zum ersten Ausgangstransistor versichert, dessen Basis an die Basis des ersten Ausgangstransistors (T2a) angeschlossen ist, der über seinen Emitter ein Spannungssignal liefert, von dem ein Teil der Basis des vierten Ausgangstransistors (T3b) zugeführt wird und, symmetrisch, wird die Kopplung zwischen dem Kollektor des zusätzlichen Eingangstransistors (T1b) und der Basis des zweiten Ausgangstransistors (T3a) von einem Nebentransistor (T4b) zum dritten Ausgangstransistor versichert, dessen Basis an die Basis des dritten Ausgangstransistors (T2b) angeschlossen ist und über seinen Emitter ein Spannungssignal liefert, von dem ein Teil der Basis des zweiten Ausgangstransistors (T3a) angeschlossen ist.

3. Verstärker nach Anspruch 2, dadurch gekennzeichnet, daß der besagte Eingangstransistor (T1a) und der zusätzliche Eingangstransistor (T1b) als differentielles Paar angeordnet sind.

4. Verstärker nach Anspruch 2, dadurch gekennzeichnet, daß der Teil der Spannung, die jeweils den Basen des zweiten (T3a) und vierten (T3b) Ausgangstransistoren zugeführt wird, einer Divisorbrücke entnommen wird, die an einem ihrer Zweige eine Diode (D1, D2) in Serie enthält.

5. Verstärker nach Anspruch 3, dadurch gekennzeichnet, daß der Emitter des besagten Eingangstransistors (T1a) und der Emitter des zusätzlichen Eingangstransistors (T1b) jeweils von einer Stromquelle versorgt werden und über einen sogenannten ersten Emitterwiderstand (R11) aneinandergekoppelt sind.

6. Verstärker nach Anspruch 5, dadurch gekennzeichnet, daß der Emitter des zweiten Ausgangstransistors (T3a) und der Emitter des vierten Ausgangstransistors (T3b) über einen sogenannten zweiten Emitterwiderstand (R10c) aneinandergekoppelt sind.

7. Verstärker nach einem der Ansprüche 1 bis 6, dadurch gekennzeichnet, daß ein Gegenkopplungswiderstand (R100) direkt zwischen dem gemeinsamen Punkt des ersten (T2a) und des zweiten (T3a) Ausgangstransistors und der Basis des besagten Eingangstransistors (T1a) angeschlossen ist, und ein anderer Gegenkopplungswiderstand (R200) direkt zwischen dem gemeinsamen Punkt des dritten (T2b) und des vierten (T3b) Ausgangstransistors und der Basis des zusätzlichen Transistors (T1b) angeschlossen ist.

8. Verstärker nach Anspruch 7, dadurch gekennzeichnet, daß ein sogenannter Basiswiderstand (R110, R210) zwischen einer Gleichtaktspannung (V2) und einerseits der Basis des besagten Eingangstransistors (T1a), respektive andererseits der Basis des zusätzlichen Eingangstransistors (T1b) angeschlossen ist.

## Claims

1. An amplifier comprising a first output transistor (T2a) and a second output transistor (T3a) having the same polarity and arranged in push-pull configuration, and an input transistor (T1a) whose collector is coupled to the base of the first output transistor (T2a),
characterized in that the amplifier also comprises a third output transistor (T2b) and a fourth output transistor (T3b) which are also arranged in push-pull configuration, and a supplementary input transistor (T1b) whose emitter is coupled to the emitter of said input transistor (T1a) and whose collector is coupled to the base of the second output transistor (T3a) and to the base of the third output transistor (T2b), the base of the fourth output transistor (T3b) being coupled to the collector of said input transistor (T1a).

2. An amplifier as claimed in claim 1, characterized in that the coupling between the collector of said input transistor (T1a) and the base of the fourth output transistor (T3b) is ensured by a transistor (T4a) which is supplementary to the first output transistor and whose base is connected to the base of the first output transistor (T2a), supplying, via its emitter, a voltage signal, a fraction of which is applied to the base of the fourth output transistor (T3b), and, symmetrically, the coupling between the collector of the supplementary input transistor (T1b) and the base of the second output transistor (T3a) is ensured by a transistor (T4b) which is supplementary to the third output transistor and whose base is connected to the base of the third output transistor (T2b) supplying, via its emitter, a voltage signal, a fraction of which is applied to the base of the second output transistor (T3a).

3. An amplifier as claimed in claim 2, characterized in that said input transistor (T1a) and the supplementary input transistor (T1b) are arranged as a differential pair.

4. An amplifier as claimed in claim 2, characterized in that the fraction of the voltages applied to the bases of the second output transistor (T3a) and the fourth output transistor (T3b) is derived from a divider bridge which includes a series-arranged diode (D1, D2) in one of its branches.

5. An amplifier as claimed in claim 3, characterized in that the emitter of said input transistor (T1a) and the emitter of the supplementary input transistor (T1b) are each fed by a current source and are mutually coupled by means of a first emitter resistor (R11).

6. An amplifier as claimed in claim 5, characterized in that the emitter of the second output transistor (T3a) and the emitter of the fourth output transistor (T3b) are mutually coupled by means of a second emitter resistor (R10c).

7. An amplifier as claimed in any one of claims 1 to 6, characterized in that a negative feedback resistor (R100) is directly connected between the common point of the first (T2a) and the second output transistor (T3a) and the base of said input transistor (T1a), and a further negative feedback resistor (R200) is directly connected between the common point of the third (T2b) and the fourth output transistor (T3b) and the base of the supplementary output transistor (T1b).

8. An amplifier as claimed in claim 7, characterized in that a base resistor (R110, R210) is connected between a common mode voltage (V2) and the base of said input transistor (T1a) and the base of the supplementary input transistor (T1b), respectively.

FIG. 1

FIG. 2